(19) Europäisches Patentamt
European Patent Office
Office européen des brevets

(11) **EP 3 438 856 B1**

(12) **EUROPÄISCHE PATENTSCHRIFT**

(45) Veröffentlichungstag und Bekanntmachung des Hinweises auf die Patenterteilung:
**09.06.2021 Patentblatt 2021/23**

(51) Int Cl.:
*G06F 30/15* *(2020.01)*   *G06F 30/20* *(2020.01)*

(21) Anmeldenummer: **18186770.6**

(22) Anmeldetag: **01.08.2018**

(54) **VERFAHREN ZUM MODELLIEREN EINES KRAFTFAHRZEUG-SENSORS IN EINER VIRTUELLEN TESTUMGEBUNG**

METHOD FOR MODELLING A MOTOR VEHICLE SENSOR IN A VIRTUAL TEST ENVIRONMENT

PROCÉDÉ DE MODÉLISATION D'UN CAPTEUR DE VÉHICULE AUTOMOBILE DANS UN ENVIRONNEMENT D'ESSAI VIRTUEL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.08.2017 DE 102017213214**

(43) Veröffentlichungstag der Anmeldung:
**06.02.2019 Patentblatt 2019/06**

(73) Patentinhaber: **Ford Global Technologies, LLC Dearborn, MI 48126 (US)**

(72) Erfinder:
• **Stefan, Frederic**
**52072 Aachen (DE)**
• **Chevalier, Alain**
**4841 Henri-Chapelle (BE)**
• **Marbaix, Michael**
**5351 Haillot (BE)**
• **Bitsanis, Evangelos**
**52062 Aachen (DE)**

(74) Vertreter: **Markowitz, Markus Ford-Werke GmbH Abt. NH/364 Henry-Ford-Straße 1 50735 Köln (DE)**

(56) Entgegenhaltungen:
• **CHRIS GOODIN ET AL: "Sensor modeling for the Virtual Autonomous Navigation Environment", IEEE SENSORS 2009 CONFERENCE, 25. Oktober 2009 (2009-10-25), Seiten 1588-1592, XP031618899, ISBN: 978-1-4244-4548-6**

**Beschreibung**

Die Erfindung betrifft ein Verfahren zum Modellieren eines Kraftfahrzeug-Sensors in einer virtuellen Testumgebung, insbesondere einer dreidimensionalen Testumgebung.

C. Coddin et al: "Sensor modelling for the Virtual Autonomous Navigation Environment", IEEE SENSORS 20009 Conference, Seiten 1588-1592, XP031618899, offenbart ein Verfahren mit den Merkmalen des Oberbegriffs des Patentanspruchs 1.

Virtuelles Testen und virtuelles Entwickeln sind notwendige Verfahren zur Entwicklung von Konstruktionsmerkmalen für automatisiertes Fahren geworden. Ein Schlüsselelement solcher virtuellen Simulationen ist die Verwendung von Modellen virtueller Sensoren in der virtuellen Testumgebung. Es gibt viele Arten, virtuelle Sensoren zu modellieren (Idealverhalten, statistisches Modell, physikalisches Modell, phänomenologisches Modell usw.).

Mit dem Auftauchen von Konstruktionsmerkmalen für automatisiertes Fahren und autonom fahrende Kraftfahrzeuge stehen das Entwerfen und Testen der zugehörigen Software neuen Herausforderungen gegenüber. Aufgrund der Natur der zur Implementierung von automatisierten Fahren benutzten Algorithmen werden eine große Zahl von Tests erforderlich, um die entsprechende Software zu validieren. Auf der einen Seite ist die Erstellung von realen Prototypen und Testumgebungen zeit- und kostenintensiv. Auf der anderen Seite werden das Durchführen und Fahren von Tests ein langwieriger Prozess, wegen der hohen Kilometerzahl, die notwendig ist, um die in automatisierten Merkmalen implementierten Algorithmen zu verifizieren. Aus diesen Gründen werden Verfahren zum virtuellen Testen immer verbreiteter. Sie ermöglichen es, Software auf Fahrzeug-Ebene in physikbasierten virtuellen Umgebungen und in immer realistischeren Umgebungen zu testen.

Ein Schlüsselaspekt von virtuellen Testumgebungen ist die Fähigkeit, Sensoren mit unterschiedlichen Genauigkeitsgraden in Abhängigkeit von den Erfordernissen des Tests zu modellieren. Das Modellieren der Sensoren ist wesentlich, da sie die Augen und Ohren des Algorithmus für automatisiertes Fahren sind. Man hat verschiedene Verfahren entwickelt, um kamerabasierte Sensoren zu testen, indem reale

Kameras mit Bildern aus einer virtuellen Realität versorgt werden, welche heutzutage mit einem sehr hohen Grad an Realismus erzeugt werden können. Für "wellenbasierte" Sensoren (Ultraschall, Radar, Lidar, Laser usw.) gibt es unterschiedliche Modellierungsmethoden wie z. B. ideales Modell, statistisches Modell bis hin zu physikalischen Modellen.

Die Verwendung von physikalischen Sensormodellen in einer virtuellen Testumgebung ist wegen der Komplexität solcher Sensoren sehr herausfordernd. Physikalische Sensormodelle erfordern eine Menge Rechenleistung und Speicher, viel Erfahrung und eine virtuelle Testumgebung, die im Stande ist, die mit der Wellenausbreitung verknüpften physikalischen Ereignisse zu modellieren, z. B. unterschiedliche Schallgeschwindigkeiten je nach atmosphärischen Bedingungen, Störungen aufgrund von Regen, Schnee, Bäumen, bewegtem Gras usw. Außerdem erfordert ein Konstruktionsmerkmal für automatisiertes Fahren im Allgemeinen eine große Zahl von Sensorinformationen, was die Verwendung solcher Sensormodelle für virtuelle Test beschränkt.

Die DE 10 2016 100 416 A1 offenbart die Verwendung einer virtuellen Umgebung zum Testen und Trainieren von realen Sensoren mittels eines virtuellen Sensors. Es wird vorgeschlagen, in der virtuellen Umgebung verarbeitete Kalibrierungen direkt auf einen realen Sensor hochzuladen. Es wird die Verwendung von Sensormodellen erwähnt, jedoch ohne Details zu nennen, wie diese Modelle auf eine formalisierte und systematische Weise erzeugt werden könnten. Der virtuelle Sensor kann Bildbasiert (inklusive "Depth Buffer") oder Raycasting-basiert sein. Dies sind heutzutage die beiden Standard-Techniken zum Modellieren eines Sensors in einer virtuellen Umgebung. Dies gibt aber keinen Anhaltspunkt, auf welche Weise diese Techniken zum Modellieren des Sensors verwendet werden. Es ist auch erwähnt, Rohdaten des virtuellen Sensors per Ray-Tracing bereitzustellen, z. B. dass ein virtueller Lidar-Sensor die vollständige Punktewolke ausgeben kann, die ein realer Lidar-Sensor ausgeben kann, jedoch ohne Hinweis, wie der Lidar-Sensor in der virtuellen Umgebung zu modellieren wäre.

Die US 2016 0 236 683 A1 schlägt die Verwendung eines parametrisierten mathematischen Modells zum Modellieren von Sensoren vor.

Die US 2009 0 300 422 A1 schlägt statistische Methoden zum Erzeugen von virtuellen Sensordaten vor.

Die NIST-Publikation 'Safe Control of Manufacturing Vehicles Research Towards Standard Test Methods', Bostelman, R. et al., 7. Juni 2012, http://www.mhi.org/downloads/learning/cicmhe/colloquium/2012/bostelman.pdf, schlägt ein Verfahren vor, ein 3D-Fahrzeugmodell mittels Raycasts zu modellieren, um einige räumliche Merkmale dieses 3D-Modells zu gewinnen.

Die Publikation 'A Simulation and Regression Testing Framework for Autonomous Vehicles', C.K. Miller et al., August 2007, http://engr.case.edu/cavusoglu_cenk/papers/ChristianMillerMS2007.pdf, beschreibt eine Simulations- und Testumgebung für autonome Fahrzeuge, die das Regressionstesten von entsprechender Software ermöglicht, d. h. die Prüfung, ob sich eine modifizierte Software in gewissen Punkten noch wie eine frühere Version der Software verhält.

Die US 8 705 792 offenbart Objektverfolgungsmechanismen und Verfahren, die Raycasting-Technik verwenden.

Die US 9 176 662 beschreibt, wie Raycasts verwendet werden können, um das Verhalten wie z. B. die Reflexion von Licht zu modellieren, um Kameralinsen zu testen.

In dem genannten Stand der Technik werden virtuelle Simulationen und Testumgebungen präsentiert und wird die Verwendung von virtuellen Sensoren erwähnt, doch wird nicht konkret beschrieben, wie die virtuellen Sensoren zu modellieren sind. Der Erfindung liegt die Aufgabe zu Grunde, ein systematisches und allgemein verwendbares Verfahren zum Modellieren eines virtuellen Sensors in einer virtuellen Umgebung bereitzustellen.

Diese Aufgabe wird durch ein Verfahren mit den Merkmalen des Patentanspruchs 1 gelöst.

Vorteilhafte Weiterbildungen der Erfindung sind in den abhängigen Patentansprüchen angegeben.

Die Erfindung stellt ein Verfahren zum Modellieren eines virtuellen Sensors in einer virtuellen Testumgebung bereit, dass auf der sog. Raycasting-Technik basiert und sich besonders zum Modellieren von Sensoren eignet, die auf der Ausbreitung von Wellen basieren, wie z. B. Ultraschall, Radar, Lidar, Laser usw.

Insbesondere umfasst ein Verfahren zum Modellieren eines Kraftfahrzeug-Sensors in einer virtuellen Testumgebung Definitionen einer Sensorstütze, einer Raycast-Verteilungsform, einer Gruppe von Raycast-Eigenschaften, eines Raycast-Reflexionsfaktors und eines Raycast-Echos.

Das erfindungsgemäße Verfahren basiert auf dem bei Computerspielen (und bei Computerspiel-Entwicklungsumgebungen, sogenannten Game Engines) verbreiteten Raycasting. Dessen Kernidee ist, die Sichtlinie eines Sensors in drei Dimensionen abzubilden und Größen wie räumliche Auflösung, zeitliche Auflösung, Geschwindigkeit usw. mit einer Raycast-Verteilung abzubilden. Die Raycast-Verteilung kann entweder mittels einer Modellierung von Grund auf in der virtuellen Testumgebung gewonnen werden oder durch ein automatisches Generierungsverfahren auf Basis der Eigenschaften von realen Sensoren, was die bevorzugte Implementierung der vorliegenden Erfindung ist.

Die Erfindung ermöglicht es, einen virtuellen Sensor auf eine formalisierte und allgemein verwendbare Weise als Objekt der virtuellen Umgebung und unter Verwendung einer Raycasting-Technik als Baustein zu modellieren.

Die Merkmale der Erfindung zu realisieren, bedeutet auch, die Natur eines Raycast zu modifizieren, der von Haus aus ein Momentan-Objekt in der virtuellen Umgebung ist, d. h., Ergebnisse sind auf jeder Verarbeitungsstufe verfügbar. Somit ergeben sich eine neue Art von Sensor-Raycast sowie ein neuer Algorithmus, der im Stande ist, Daten von realen Sensoren in Raycast-Layouts und Raycast-Parameter zu zerlegen.

Zum Beispiel stelle man sich vor, einen Ultraschallsensor für einen Einparkassistenten modellieren zu wollen. Man könnte einfach einen Raycast senkrecht auf ein dreidimensionales Fahrzeugmodell in der virtuellen Umgebung schicken. Dies würde genügen, falls Algorithmen zu bewerten sind, die eine Distanz zum nächsten Hindernis benutzen. Doch falls Algorithmen zu bewerten sind, die es ermöglichen, die Distanz zum nächsten Hindernis auf Basis der Ausbreitung von Schallwellen zu bestimmen, reicht ein einfacher Raycast nicht aus, und man bräuchte nicht nur ein Sensormodell für einen bestimmten Sensor, sondern eine Vielzahl von Sensormodellen in Abhängigkeit vom Testfall. Die Erfindung ermöglicht es, das Sensormodell an die individuellen Bedürfnisse der Benutzer anzupassen.

In der o. g. DE 10 2016 100 416 A1 soll das Sensorverhaltensmodell als Teil von Nachverarbeitungsalgorithmen implementiert werden, die durch einen gemeinsamen Speicher auf den Raycast zugreifen.

Bei der Erfindung liefern die Sensormodelle von Haus aus ein vollständiges Spektrum von Daten in Zeit und Raum, und es ist kein Nachverarbeitungsalgorithmus erforderlich, um die Daten zu gewinnen.

So haben die Erfinder ein LIDAR-Sensormodell in einer dreidimensionalen Umgebung entwickelt, das einem sehr große Freiheiten gibt. So könnte man sich z. B. für ein Bündel von 64 Raycasts entscheiden, die wie in der Realität mit hoher Frequenz rotieren, oder man könnte sich für ein Bündel von N Raycasts entscheiden, die einen Bereich von 360° rings um ein Fahrzeugmodell abdecken und mit niedrigerer Frequenz aufgefrischt werden. Die Art und Weise, den Sensor mit Raycasts zu modellieren, liefert dem Entwickler unterschiedliche Informationen und somit Ergebnisse. Dies zeigt die Wichtigkeit einer Beschreibung, wie der Sensor zu modellieren ist.

Jeder Sensor hat seine spezifischen Eigenschaften, und jede Phase eines Projekts erfordert ein anderes Sensormodell. Jeden Sensor ad hoc zu modellieren, würde eine lange Zeit dauern und den Entwickler zwingen, sich jedes Mal von neuem zu fragen, wie er vorgehen muss, um die Sensoren zu modellieren. Hingegen ist das erfindungsgemäße Verfahren von allgemeiner Natur und kann automatisiert werden. Zum Beispiel könnte man sich einen elektronischen Assistenten vorstellen, der einen durch den Prozess der Sensormodellierung und -erzeugung leitet.

In einer bevorzugten Ausführungsform ist die Sensorstütze eine virtuelle Sensorstütze für ein virtuelles Sensormodell, die einen drei- oder zweidimensionalen Avatar des Sensors in der virtuellen Testumgebung bildet und einen Sensor-Ausgangspunkt oder eine Sensor-Ausgangsfläche aufweist, der bzw. die als Ursprung für eine Raycast-Verteilungsform bzw. deren Raycasts dient.

Die Raycast-Verteilungsform kann eine vorgegebene zwei- oder dreidimensionale Form sein, deren Ursprung der Ausgangspunkt oder die Ausgangsfläche der Sensorstütze ist, wobei die Raycast-Verteilungsform eine Vielzahl von gleichverteiltem Raycasts aufweist, deren Ursprung entweder der Ausgangspunkt der Sensorstütze oder ein Punkt in der Ausgangsebene der Sensorstütze ist.

Die Raycast-Eigenschaften sind insbesondere eine Dämpfung, eine Ausbreitungsgeschwindigkeit und eine Erfassungsgenauigkeit von Raycasts.

Das Verfahren eignet sich besonders zum Modellieren von Sensoren, die auf Basis von elektromagnetischen oder akustischen Wellen arbeiten.

Es folgt eine Beschreibung von Ausführungsbeispielen anhand der Zeichnungen. Darin zeigen:

Fig. 1 eine Darstellung eines Raycast;

Fig. 2 eine Systemübersicht; und

Fig. 3 ein Beispiel für ein Sensormodell.

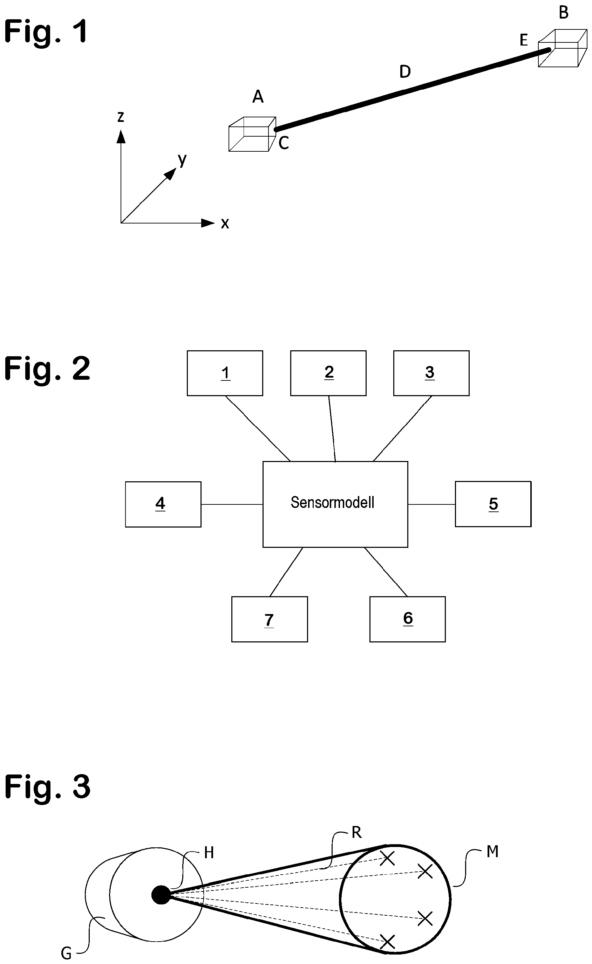

Zur Erläuterung von Raycasts wird zunächst auf Fig. 1 Bezug genommen.

Bei einem Computerspiel (oder bei einer Computerspiel-Entwicklungsumgebung, Game Engine) ist ein Raycast oder "Sehstrahl" etwas, das durch mindestens einen Vektor D in drei Dimensionen in einem dreidimensionalen Bezugskoordinatensystem xyz dargestellt wird, der eine bestimmte Länge (bis hin zu unendlich) und einen auf einem Objekt A platzierten Anlegungspunkt oder Ursprung C hat. Raycasts bieten die Möglichkeit, alle Objekte B aufzufinden, die sich auf deren Trajektorie befinden, was es insbesondere erlaubt, die Koordinaten von Kontaktpunkten E zwischen den Raycasts und diesen Objekten aufzufinden. Typischerweise werden Raycasts benutzt, um augenblicklich Projektil-Trajektorien zu emulieren, um die Sichtbarkeit von Objekten zu ermitteln, usw.

Das Sensormodell besteht aus den folgenden, in Fig. 2 dargestellten Teilen:

1.) Einer Definition einer Sensorstütze 1.
Die Sensorstütze 1 ist der "Avatar" des Sensors in der virtuellen Testumgebung und hat die folgenden Eigenschaften:

- Ein Ausgangspunkt oder eine Ausgangsfläche (d. h., ein Ursprung) für eine Raycast-Verteilungsform 2;

- Eine 3D-Rotationsbewegung in Abhängigkeit von der Zeit, die anzeigt, ob der Sensor zum Beispiel mit einer bestimmten Winkelgeschwindigkeit rotieren kann oder ob der Sensor feststehend ist.

2.) Einer Raycast-Verteilungsform 2:

- Die Raycast-Verteilungsform 2 ist eine dreidimensionale Form (wie z. B. ein Kegel, ein Zylinder oder ein gebräuchliches Volumen), deren Ursprung der Ausgangspunkt oder die Ausgangsfläche der Sensorstütze 1 ist.

- Die Abmessungen der Raycast-Verteilungsform 2 modellieren die maximale Reichweite des Sensors im Dreidimensionalen.

- Die Raycast-Verteilung enthält N Raycasts, die in der Raycast-Verteilungsform 2 gleichverteilt sind. Der Ursprung jedes Raycast ist entweder der Ausgangspunkt der Sensorstütze 1 oder ein Punkt in der Ausgangsebene der Sensorstütze 1.

- Die Anzahl der Raycasts ergibt die räumliche Auflösung des Sensors. Sie kann auch verwendet werden, um Diskretisierung von Sensorinformationen zu modellieren.

3.) Einer Definition einer Raycast-Dämpfung 3:

- Die Dämpfung 3 kann für alle Raycasts der Raycast-Verteilungsform 2 identisch sein oder kann für jeden Raycast spezifisch sein.

- Die Dämpfung 3 kann ein Koeffizient oder eine Formel innerhalb der Raycast-Verteilungsform 2 sein, der bzw. die den Prozentsatz des Ursprungsignals angibt, der zurückkehren würde, falls ein Objekt in einer bestimmten Distanz vom Ursprung von dem Raycast getroffen wird.

4.) Einer Definition einer Raycast-Ausbreitungsgeschwindigkeit 4:

- Die Ausbreitungsgeschwindigkeit 4 kann für alle Raycasts der Raycast-Verteilungsform 2 identisch sein oder kann für jeden Raycast spezifisch sein.

- Die Ausbreitungsgeschwindigkeit 4 dient zum Definieren der Verzögerung, nach der bei der Distanz, in der der Raycast ein Objekt trifft, der Echo-Wert des Raycast im Sensor zur Verfügung steht.

- Die Ausbreitungsgeschwindigkeit 4 kann zum Modellieren der Natur der von dem Sensor emittierten Wellen (Schall, Licht, elektromagnetisch usw.) und von Umgebungseinflüssen wie z. B. Wetter, Temperatur usw. verwendet werden.

5.) Einer Definition einer Raycast-Erfassungsgenauigkeit 5:

- Die Erfassungsgenauigkeit 5 kann für alle Raycasts der Raycast-Verteilungsform 2 identisch sein oder kann für jeden Raycast spezifisch sein.

- Die Erfassungsgenauigkeit 5 ist ein Korrekturkoeffizient, der es erlaubt, einen Fehler im Echo-Wert des Raycast zu emulieren. Sie ist eine Wahrscheinlichkeit, dass ein Raycast einen fehlerhaften Wert zurückschickt (z. B. in erster Linie wegen fehlendem Ziel, eventuell Fehlalarm).

6.) Einer Definition eines Reflexionsfaktors 6:

- Die Definition eines Reflexionsfaktors 6 ist den in der virtuellen Testumgebung vorhandenen Objekten zugeordnet.

- Der Reflexionsfaktor ist ein Prozentsatz, der repräsentiert, wie gut ein Objekt die von dem Sensor emittierte Welle reflektiert.

- Der Reflexionsfaktor erlaubt es, Materialien zu modellieren, die aufgrund ihrer Form, Struktur, Natur usw. nur schwach reflektieren, wie z. B. manche Kleidungsstücke.

7.) Einer Definition eines Raycast-Echos 7:

- Jeder Raycast kann eine Sammlung von Werten zurückschicken, die ein Echo genannt werden, nämlich

a) eine 3D-Koordinate, die dem Treffpunkt mit einem Objekt entspricht (oder nichts, wenn es keinen Treffer gibt), und

b) einen im Bereich [0, ..., 1] liegenden Echowert, der von der Erfassungsgenauigkeit 5, dem Wert der Dämpfung 3, dem Reflexionsfaktor 6 des getroffenen Objekts und davon abhängt, ob ein Treffer vorhanden ist oder nicht. Er kann durch die folgende Beziehung gegeben sein:

Genauigkeitswert = (Erfassungsgenauigkeit) × (Dämpfung) × (Reflexionsfaktor) ×

(1 für einen Treffer oder andernfalls 0)

- Jeder Wert eines Raycast-Echos 7 steht nach einer Ausbreitungszeit zur Verfügung, die durch die für diesen Raycast definierte Ausbreitungsgeschwindigkeit 4 und die Distanz des getroffenen Objekts vom Ursprung des Raycast bestimmt wird.

Falls erforderlich, ist es auch möglich, einen Sensor nur in zwei Dimensionen zu modellieren.

Fig. 3 zeigt ein Beispiel für ein Sensormodell. In Fig. 3 ist G die Sensorstütze 1, die aus einem Zylinder besteht und der 3D-Avatar des Sensors ist, der in eine virtuelle Umgebung und auf einen Ausgangspunkt H gesetzt ist, welches der Ursprung der Raycast-Verteilungsform M ist. Die Raycast-Verteilungsform M ist ein Kegel; die Abmessung des Kegels liefert die maximale Reichweite des Sensors im dreidimensionalen Raum. Diese Raycast-Verteilungsform M enthält vier Raycasts R, was bedeutet, dass dieser Sensor ein Objekt erfassen kann, das diese Raycasts R quert. Für jeden Raycast R können eine Dämpfung 3, eine Ausbreitungsgeschwindigkeit 4 und eine Erfassungsgenauigkeit 5 definiert werden.

Es ist möglich, das Sensormodell automatisch zu erzeugen, unter anderem auf Basis des Folgenden:

- Messungen des Sensors in der Realität, welche von einem Algorithmus für maschinelles Lernen analysiert werden, der trainiert ist, die zum Modellieren des Sensors erforderlichen Parameter zu extrahieren.

- Testfälle oder Anwendungsfälle, die in einer maschineninterpretierbaren Sprache (z. B. einer pseudonatürlichen Sprache) spezifiziert sind und welche von einem Algorithmus analysiert werden, der die spezielle Anwendung des Sensors im Anwendungsfall extrahiert. Dies ist besonders nützlich zum Testen von Fehlerszenarien oder sicherheitsbezogenen Szenarien.

- Sensor-Datenblätter, die in einem Standardformat wie z. B. XML zur Verfügung stehen und von einem Sensor-Lieferanten bereitgestellt werden. Ein Algorithmus wie z. B. ein Serialisierer kann die zum Modellieren des Sensors erforderlichen Parameter aus derartigen digitalen Datenblättern extrahieren.

Zusammengefasst sind die folgenden Verfahren bzw. Algorithmen wesentlich:
Ein Verfahren zum Modellieren eines virtuellen Kraftfahrzeug-Sensors in einer dreidimensionalen virtuellen Umgebung durch Definition und Verwendung einer Sensorstütze 1, einer Raycast-Verteilungsform 2, Raycast-Eigenschaften, insbesondere dessen Dämpfung 3, Ausbreitungsgeschwindigkeit 4 und Erfassungsgenauigkeit 5, eines Raycast-Reflexionsfaktors 6 und eines Raycast-Echos 7, welches ein zurückgeschickter Wert des Raycast ist.
Ein Verfahren zum Definieren einer virtuellen Sensorstütze für ein virtuelles Sensormodell, mit

- einem drei- oder zweidimensionalen Avatar des Sensors in einer rein grafischen Darstellung;
- einem Sensor-Ausgangspunkt oder einer Sensor-Ausgangsfläche, der bzw. die als Ursprung für eine Raycast-Verteilungsform bzw. deren Raycasts dient; und
- einer Definition einer Sensorstützen-Bewegung, die beschreibt, ob die Sensorstütze eine feste Stütze ist oder ob sie sich nach Anbringung an einem virtuellen Objekt bewegen kann (wie es z. B. bei Lidar oder rotierendem Radar der Fall ist). Wenn sich der Sensor bewegen kann, wird die zugehörige Bewegung ebenfalls beschrieben (z. B. Rotationsgeschwindigkeit, usw.).

Ein Verfahren zum Definieren einer Raycast-Verteilungsform für ein virtuelles Sensormodell, wobei:

- die Raycast-Verteilungsform eine dreidimensionale (wie z. B. ein Kegel, ein Zylinder oder ein gebräuchliches Volumen) oder zweidimensionale Form ist, deren Ursprung der Ausgangspunkt oder die Ausgangsfläche der Sensorstütze ist;

- die Abmessungen der Raycast-Verteilungsform die maximale Reichweite des Sensors im Dreidimensionalen oder Zweidimensionalen modellieren;

- die Raycast-Verteilung N Raycasts enthält, die einer bestimmten Verteilung in der Raycast-Verteilungsform folgen, typischerweise einer Gleichverteilung, wobei der Ursprung jedes Raycast entweder der Ausgangspunkt der Sensorstütze oder ein Punkt in der Ausgangsebene der Sensorstütze ist; und

- die Anzahl der Raycasts die räumliche Auflösung des Sensors ergibt und auch verwendet werden kann, um Diskretisierung von Sensorinformationen zu modellieren.

Ein Verfahren zum Definieren einer Dämpfung für jeden Raycast einer Raycast Verteilungsform, wobei:

- die Dämpfung für alle Raycasts der Raycast-Verteilungsform dieselbe ist oder für jeden Raycast spezifisch ist, um Grenzen zu modellieren oder Bedingungen zu begrenzen;

- die Dämpfung typischerweise als ein Prozentsatz im Bereich [0, ..., 1] ausgedrückt wird; und

- die Dämpfung als ein Einzelwert oder eine Formel definiert wird, der bzw. die den Prozentsatz des Ursprungsignals angibt, der zurückkehren würde, falls innerhalb der Raycast-Verteilungsform ein Objekt in einer bestimmten Distanz vom Ursprung von dem Raycast getroffen wird.

Ein Verfahren zum Definieren einer Raycast-Ausbreitungsgeschwindigkeit, wobei:

- die Ausbreitungsgeschwindigkeit für alle Raycasts der Raycast-Verteilungsform dieselbe ist oder für jeden Raycast spezifisch ist;

- die Ausbreitungsgeschwindigkeit verwendet wird, um die Verzögerung zu definieren, nach der bei der Distanz, in der ein Raycast ein Objekt trifft, ein Echo-Wert des Raycast im Sensor zur Verfügung steht; und

- die Ausbreitungsgeschwindigkeit verwendet wird, um die Natur der von dem Sensor emittierten Wellen (Schall, Licht, elektromagnetisch usw.) und Umgebungseinflüsse wie z. B. Wetter, Temperatur usw. zu modellieren.

Ein Verfahren zum Definieren einer Raycast-Erfassungsgenauigkeit, wobei:

- die Erfassungsgenauigkeit für alle Raycasts der Raycast-Verteilungsform identisch ist oder für jeden Raycast spezifisch ist; und

- die Erfassungsgenauigkeit ein Korrekturkoeffizient ist, der es erlaubt, einen Fehler im Echo-Wert des Raycast zu emulieren. Sie ist eine Wahrscheinlichkeit, dass ein Raycast einen fehlerhaften Wert zurückschickt (z. B. in erster Linie wegen fehlendem Ziel, eventuell Fehlalarm).

Ein Verfahren zum Definieren einer Raycast-Erfassungsgenauigkeit, wobei:

- die Erfassungsgenauigkeit für alle Raycasts der Raycast-Verteilungsform dieselbe ist oder für jeden Raycast spezifisch ist;

- die Erfassungsgenauigkeit typischerweise als ein Prozentsatz im Bereich [0, ..., 1] ausgedrückt wird;

- die Erfassungsgenauigkeit ein Korrekturkoeffizient ist, der es erlaubt, einen Fehler im Echo-Wert des Raycast zu emulieren (zum Beispiel kann sie eine Wahrscheinlichkeit darstellen, dass ein Raycast einen fehlerhaften Wert zurückschickt (z. B. in erster Linie wegen fehlendem Ziel, eventuell Fehlalarm); und

- die Erfassungsgenauigkeit in einer frühen Phase eines Projekts verwendet wird, um Fehler zu emulieren, die durch in einen Sensor eingebettete Signalverarbeitungsalgorithmen hervorgerufen werden.

Ein Verfahren zum Definieren eines Aktivierungszeit-Musters für jeden Raycast einer Raycast-Verteilungsform, wobei das Aktivierungszeit-Muster verwendet wird, um zu spezifizieren, wann jeder Raycast eines Sensors aktiviert wird (z. B. alle zusammen, einer nach dem anderen mit einer bestimmten Verzögerung, usw.).

Ein Verfahren zum Definieren eines Reflexionsfaktors für ein virtuelles Objekt eines virtuellen Sensortests, wobei:

- die Definition eines Reflexionsfaktors einem bestimmten Material zugeordnet ist, das einem jeden Objekt in der virtuellen Testumgebung zugeordnet ist;

- der Reflexionsfaktor typischerweise als ein Prozentsatz im Bereich [0, ..., 1] ausgedrückt wird;

- der Reflexionsfaktor ein Prozentsatz ist, der repräsentiert, wie gut ein Objekt die von dem Sensor emittierte Welle reflektiert; und

- der Reflexionsfaktor es erlaubt, Materialien zu modellieren, die aufgrund ihrer Form, Struktur, Natur usw. nur schwach reflektieren (wie z. B. manche Kleidungsstücke).

Ein Verfahren zum Definieren eines Echos für jeden Raycast eines Sensormodells, wobei:

- für jeden Raycast des Sensormodells ein Echo verarbeitet wird;

- ein Echo ein Wert im Bereich [0, ..., 1] ist, der eine Funktion des Dämpfungswerts, der Erfassungsgenauigkeit und des Reflexionsfaktors des von dem Raycast getroffenen Objekts und von dem Vorhandensein eines Treffers ist;

- ein Echo-Wert nach einer Zeitverzögerung zur Verfügung steht, die eine Funktion der Raycast-Ausbreitungsgeschwindigkeit und der Distanz des getroffenen Objekts ist; und

- ein Echo-Wert den drei- oder zweidimensionalen Koordinaten des getroffenen Objekts zugeordnet ist.

Ein Verfahren zum automatischen Erzeugen eines virtuellen Sensormodells, wobei:

- das Verfahren ein Algorithmus für maschinelles Lernen ist, der trainiert wird, die zum Modellieren des Sensors erforderlichen Parameter aus Messungen des Sensors in der Realität zu extrahieren;

- das Verfahren ein Algorithmus ist, der einen Testfall oder Anwendungsfall analysiert, der in einer maschineninterpretierbaren Sprache (z. B. einer pseudonatürlichen Sprache) spezifiziert ist, und die spezielle Anwendung des Sensors in dem Testfall oder Anwendungsfall extrahiert (besonders nützlich zum Testen von Fehlerszenarien oder sicherheitsbezogenen Szenarien); und

- das Verfahren ein Algorithmus ist, der die zum Modellieren des Sensors erforderlichen Parameter aus einem Sensor-Datenblatt extrahiert, das in einem Standardformat (z. B. XML) zur Verfügung steht und von einem Sensor-Lieferanten bereitgestellt wird.

**Patentansprüche**

1. Verfahren zum Modellieren eines Kraftfahrzeug-Sensors in einer virtuellen Testumgebung zum virtuellen testen von Software für automatisiertes Fahren und autonom fahrende Kraftfahrzeuge, wobei

   - ein Sensormodell auf Basis des Folgenden automatisch erzeugt wird:

     - Messungen eines Sensors in der Realität, welche von einem Algorithmus für maschinelles Lernen analysiert werden, der trainiert ist, die zum Modellieren des Sensors erforderlichen Parameter aus Messungen des Sensors zu extrahieren, oder
     - ein oder mehrere maschinenlesbare Sensor-Datenblätter, aus denen ein Algorithmus die zum Modellieren des Sensors erforderlichen Parameter extrahiert; und

     - der Kraftfahrzeug-Sensor in der virtuellen Testumgebung durch Definition und Verwendung einer Sensorstütze (1), einer Raycast-Verteilungsform (2), einer Gruppe von Raycast-Eigenschaften (3, 4, 5), eines Raycast-Reflexionsfaktors (6) und eines Raycast-Echos (7) basierend auf den extrahierten Parametern modelliert wird.

2. Verfahren nach Anspruch 1, wobei die Sensorstütze (1) eine virtuelle Sensorstütze (1) für ein virtuelles Sensormodell ist, die einen drei- oder zweidimensionalen Avatar des Sensors in der virtuellen Testumgebung bildet und einen Sensor-Ausgangspunkt oder eine Sensor-Ausgangsfläche aufweist, der bzw. die als Ursprung für eine Raycast-Verteilungsform bzw. deren Raycasts dient.

3. Verfahren nach Anspruch 1 oder 2, wobei die Raycast-Verteilungsform (2) eine vorgegebene zwei- oder dreidimensionale Form ist, deren Ursprung der Ausgangspunkt oder die Ausgangsfläche der Sensorstütze (1) ist, wobei die Raycast-Verteilungsform (2) eine Vielzahl von gleichverteiltem Raycasts aufweist, deren Ursprung entweder der Ausgangspunkt der Sensorstütze (1) oder ein Punkt in der Ausgangsebene der Sensorstütze (1) ist.

4. Verfahren nach einem der vorhergehenden Ansprüche, wobei die Raycast-Eigenschaften eine Dämpfung (3), eine Ausbreitungsgeschwindigkeit (4) und eine Erfassungsgenauigkeit (5) von Raycasts sind.

5. Verfahren nach Anspruch 4, wobei die Dämpfung (3) für alle Raycasts der Raycast-Verteilungsform dieselbe ist oder für jeden Raycast spezifisch ist und als ein Einzelwert oder eine Formel definiert wird, der bzw. die den Prozentsatz des Ursprungssignals angibt, der zurückkehren würde, falls ein Objekt in einer bestimmten Distanz vom Ursprung von dem Raycast getroffen wird.

6. Verfahren nach Anspruch 4 oder 5, wobei die Ausbreitungsgeschwindigkeit (4) für alle Raycasts der Raycast-Verteilungsform dieselbe ist oder für jeden Raycast spezifisch ist und die Verzögerung definiert, nach der bei der Distanz, in der ein Raycast ein Objekt trifft, ein Echo-Wert des Raycast im Sensor zur Verfügung steht.

7. Verfahren nach einem der Ansprüche 4 bis 6, wobei die Erfassungsgenauigkeit (5) für alle Raycasts der Raycast-Verteilungsform identisch ist oder für jeden Raycast spezifisch ist und eine Wahrscheinlichkeit ist, dass ein Raycast einen fehlerhaften Wert zurückschickt.

8. Verfahren nach einem der vorhergehenden Ansprüche, wobei der Reflexionsfaktor (6) den in der virtuellen Testumgebung vorhandenen Objekten zugeordnet ist und ein Prozentsatz ist, der angibt, wie gut ein Objekt die von dem Sensor emittierte Welle reflektiert.

9. Verfahren nach einem der vorhergehenden Ansprüche, wobei das Raycast-Echo (7) eine von jedem Raycast zurückgeschickte Sammlung von Koordinaten und Echowerten ist, wobei die Echowerte von der Erfassungsgenauigkeit (5), der Dämpfung (3), dem Reflexionsfaktor (6) und davon abhängen, ob ein Treffer vorhanden ist oder nicht.

10. Verfahren nach einem der vorhergehenden Ansprüche, wobei ein auf Basis von elektromagnetischen oder akustischen Wellen arbeitender Sensor modelliert wird.

**Claims**

1. Method for modelling a motor vehicle sensor in a virtual test environment for virtual testing of software for automated driving and autonomously driving motor vehicles, wherein

   - a sensor model is automatically generated on the basis of the following:

      - measurements of a sensor in reality which are analyzed by an algorithm for machine learning, which is trained to extract the parameters required for modelling the sensor from measurements of the sensor, or
      - one or more machine-readable sensor data sheets, from which an algorithm extracts the parameters required for modelling the sensor; and

      - the motor vehicle sensor is modelled in the virtual test environment by way of definition and use of a sensor support (1), a raycast distribution shape (2), a group of raycast properties (3, 4, 5), a raycast reflection factor (6), and a raycast echo (7) based on the extracted parameters.

2. Method according to Claim 1, wherein the sensor support (1) is a virtual sensor support (1) for a virtual sensor model, which forms a three-dimensional or two-dimensional avatar of the sensor in the virtual test environment and has a sensor starting point or a sensor starting surface, which is used as the origin for a raycast distribution shape or its raycasts.

3. Method according to Claim 1 or 2, wherein the raycast distribution shape (2) is a predefined two-dimensional or three-dimensional shape, the origin of which is the starting point or the starting surface of the sensor support (1), wherein the raycast distribution shape (2) has a multiplicity of evenly distributed raycasts, the origin of which is either the starting point of the sensor support (1) or a point in the starting plane of the sensor support (1).

4. Method according to any one of the preceding claims, wherein the raycast properties are a damping (3), a propagation speed (4), and a detection accuracy (5) of raycasts.

5. Method according to Claim 4, wherein the damping (3) is the same for all raycasts of the raycast distribution shape or is specific for each raycast and is defined as a single value or a formula, which specifies the percentage of the original signal which would return if an object were struck by the raycast at a specific distance from the origin.

6. Method according to Claim 4 or 5, wherein the propagation speed (4) is the same for all raycasts of the raycast distribution shape or is specific for each raycast and defines the delay, after which, at the distance at which a raycast strikes an object, an echo value of the raycast is available in the sensor.

7. Method according to any one of Claims 4 to 6, wherein the detection accuracy (5) is identical for all raycasts of the raycast distribution shape or is specific for each raycast and is a probability that a raycast sends back an incorrect value.

8. Method according to any one of the preceding claims, wherein the reflection factor (6) is associated with the objects present in the virtual test environment and is a percentage which indicates how well an object reflects the wave emitted by the sensor.

9. Method according to any one of the preceding claims, wherein the raycast echo (7) is a collection of coordinates and echo values sent back by each raycast, wherein the echo values are dependent on the detection accuracy (5), the damping (3), the reflection factor (6), and whether a hit is present or not.

10. Method according to any one of the preceding claims, wherein a sensor operating on the basis of electromagnetic or acoustic waves is modelled.

**Revendications**

1. Procédé de modélisation d'un capteur de véhicule automobile dans un environnement de test virtuel pour tester virtuellement des logiciels de conduite automatisée et des véhicules autonomes,

   - un modèle de capteur étant généré automatiquement sur la base des éléments suivants :

      - des mesures du monde réel qui sont effectuées par un capteur et qui sont analysées par un algorithme d'apprentissage automatique qui est entraîné pour extraire, des mesures du capteur, les paramètres nécessaires à la modélisation du capteur ou
      - une ou plusieurs fiches techniques de capteur, lisibles par machine, à partir desquelles un algorithme extrait les paramètres nécessaires à la modélisation du capteur ; et

   - le capteur de véhicule automobile dans l'environnement de test virtuel étant modélisé sur la base des paramètres extraits par définition et utilisation d'un support de capteur (1), d'une forme de distribution de lancers de rayon (2), d'un groupe de propriétés de lancers de rayon (3, 4, 5), d'un facteur de réflexion de lancers de rayon (6) et d'un écho de lancers de rayon (7).

2. Procédé selon la revendication 1, le support de capteur (1) étant un support de capteur virtuel (1) qui est destiné à un modèle de capteur virtuel et qui forme un avatar tridimensionnel ou bidimensionnel du capteur dans l'environnement de test virtuel et qui comporte un point de départ de capteur ou une surface de départ de capteur qui sert d'origine à une forme de distribution de lancers de rayon ou à ses lancers de rayon.

3. Procédé selon la revendication 1 ou 2, la forme de distribution de lancers de rayon (2) étant une forme bidimensionnelle ou tridimensionnelle spécifiée dont l'origine est le point de départ ou la surface de départ du support de capteur (1), la forme de distribution de lancers de rayon (2) comportant une pluralité de lancers de rayon uniformément répartis dont l'origine est soit le point de départ du support de capteur (1) soit un point dans le plan de départ du support de capteur (1).

4. Procédé selon l'une des revendications précédentes, les propriétés de lancers de rayon étant une atténuation (3), une vitesse de propagation (4) et une précision de détection (5) de lancers de rayon.

5. Procédé selon la revendication 4, l'atténuation (3) pour tous les lancers de rayon de la forme de distribution de lancers de rayon étant la même ou étant spécifique pour chaque lancer de rayon et étant définie comme une valeur unique ou une formule qui indique le pourcentage du signal d'origine qui reviendrait si un objet à une certain distance de l'origine était frappé par le lancer de rayon.

6. Procédé selon la revendication 4 ou 5, la vitesse de propagation (4) pour tous les lancers de rayon de la forme de distribution de lancers de rayon étant la même ou étant spécifique à chaque lancer de rayon et définissant le retard après lequel une valeur d'écho du lancer de rayon est disponible dans le capteur à la distance à laquelle un lancer de rayon frappe un objet.

7. Procédé selon l'une des revendications 4 à 6, la précision de détection (5) pour tous les lancers de rayon de la forme de distribution de lancers de rayon étant identique ou étant spécifique à chaque lancer de rayon et étant une probabilité qu'un lancer de rayon renvoie une valeur incorrecte.

8. Procédé selon l'une des revendications précédentes, le facteur de réflexion (6) étant associé aux objets présents dans l'environnement de test virtuel et étant un pourcentage qui indique la précision avec laquelle un objet réfléchit l'onde émise par le capteur.

9. Procédé selon l'une des revendications précédentes, l'écho de lancer de rayon (7) étant une collection de coordonnées et de valeurs d'écho renvoyées par chaque lancer de rayon, les valeurs d'écho dépendant de la précision de détection (5), de l'atténuation (3), du facteur de réflexion (6) et de la présence ou non d'un impact.

10. Procédé selon l'une des revendications précédentes, un capteur fonctionnant sur la base d'ondes électromagnétiques ou acoustiques étant modélisé.

# Fig. 1

# Fig. 2

# Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016100416 A1
- US 20160236683 A1
- US 20090300422 A1

- US 8705792 B
- US 9176662 B

**In der Beschreibung aufgeführte Nicht-Patentliteratur**

- **C. CODDIN et al.** Sensor modelling for the Virtual Autonomous Navigation Environment. *IEEE SENSORS 20009 Conference,* 1588-1592
- **BOSTELMAN, R. et al.** *Safe Control of Manufacturing Vehicles Research Towards Standard Test Methods,* 07. Juni 2012, http://www.mhi.org/downloads/learning/cicmhe/colloquium/2012/bostelman.pdf

- **C.K. MILLER et al.** *A Simulation and Regression Testing Framework for Autonomous Vehicles,* August 2007, http://engr.case.edu/cavusoglu_cenk/papers/ChristianMillerMS2007.pdf